# EUROPÄISCHE PATENTSCHRIFT

(11) **EP 0 815 712 B1**
(45) Veröffentlichungstag und Bekanntmachung des Hinweises auf die Patenterteilung: **26.05.1999**
(21) Anmeldenummer: 96905720.7
(22) Anmeldetag: 13.03.1996
(51) Int. Cl.: H05K 13/00, H05K 13/02

(54) **VERFAHREN ZUR HANDHABUNG VON ELEKTRONISCHEN BAUELEMENTEN IN DER ENDMONTAGE**
PROCESS FOR HANDLING ELECTRONIC COMPONENTS DURING FINAL ASSEMBLY
PROCEDE DE MANIPULATION DE COMPOSANTS ELECTRONIQUES LORS DU MONTAGE FINAL

(30) Priorität: 21.03.1995 DE 19510277
(43) Veröffentlichungstag der Anmeldung: 07.01.1998
(73) Patentinhaber: SIEMENS AKTIENGESELLSCHAFT, 80333 München (DE)
(72) Erfinder: HAUEIS, Norbert, D-93138 Kareth (DE); EIGENSTETTER, Peter, D-93093 Donaustauf (DE)
(86) Internationale Anmeldenummer: DE9600445
(87) Internationale Veröffentlichungsnummer: WO9629851

(56) Entgegenhaltungen:
- EP-A- 0 193 255
- WO-A-93/02952
- GB-A- 2 053 855

## Beschreibung

Die Erfindung betrifft ein Verfahren zur Handhabung von elektronischen Bauelementen. Für elektronische Bauelemente wird durch entsprechende Verfahren eine elektronische Schaltung hergestellt, die mit nach außen anschließbaren elektrischen Kontakten versehen ist. Diese werden in großen Stückzahlen zum elektrischen und mechanischen Schutz mit einem Kunststoffgehäuse umgeben. Der Bereich ihrer Herstellung, der als Endmontage bezeichnet wird, beinhaltet mehrere Stationen, in denen die fertigen Bauelemente, die sich auf einem Träger befinden, bearbeitet oder geprüft werden.

Die Bearbeitung oder Prüfung der elektronischen Bauelemente bezieht sich auf deren Funktion nach einer bestimmten Beanspruchung. Um mit statistischen Methoden die Funktionsfähigkeit der nach der Prüfung als gut befundenen elektronischen Bauelemente abschätzen zu können, werden entsprechende Strom, Spannungs- oder Temperaturbelastungen in entsprechenden Stationen durchgeführt. Dabei wird versucht, ähnliche Ausfallmechanismen herbeizuführen, wie sie im Betrieb später zu erwarten sind.

Zur Handhabung der elektronischen Bauelemente während der Bearbeitung und Prüfung werden diese je nach Auslegung einer Bearbeitungs- oder Prüfstation sehr unterschiedlich transportiert und in der Station gelagert. Die Lagerung während des Transportes zwischen den Stationen geschieht bisher häufig mittels sog. Trays (Träger), die eine Vielzahl von wannenförmigen Vertiefungen aufweisen, in denen jeweils ein Bauelement abgelegt wird. Innerhalb der Stationen werden die Bauelemente häufig auf einfachen Gitterrosten gelagert.

In der Endmontage ist die Durchlaufzeit der Bauelemente bereits aufgrund der langwierigen Temperaturbelastungsprüfungen relativ hoch. Einerseits wird aufgrund der zunehmenden Miniaturisierung der Bauelemente eine weitere Qualitätssteigerung für die entsprechenden Fertigungsverfahren notwendig. Andererseits soll zur allgemeinen Optimierung eines Herstellungsverfahrens der Materialfluß durch die entsprechende Auslegung und Abstimmung der Stationen untereinander verbessert werden. Darüber hinaus kann eine Überwachung der insgesamt durchlaufenden Bauelemente notwendig sein.

Der Erfindung liegt die Aufgabe zugrunde, Handhabungsschritte in der Endmontage von elektronischen Bauelementen zu minimieren und eine Kontrolle des Betriebsablaufes in der Endmontage zu ermöglichen.

Die Lösung dieser Aufgabe geschieht durch die Merkmale des Anspruches 1. Vorteilhafte Ausgestaltungen sind den Unteransprüchen zu entnehmen.

Der Erfindung liegt die Erkenntnis zugrunde, daß mittels einer Zusammenfassung von mehreren plattenförmigen Trägern, die ihrerseits eine Vielzahl von Bauelementen tragen, zu einem Stapel eine Fertigungseinheit von Bauelementen (ein Los) in einem den Stapel aufnehmenden Gehäuse zusammengefaßt werden kann. Mittels des Gehäuses können die Träger mit den Bauelementen zwischen den Bearbeitungs- oder Prüfstationen transportiert werden und durch Ankopplung des Gehäuses an eine Station können die Träger nacheinander in eine Station eingeladen bzw. aus einer Station ausgeladen werden. Dies ist mit einer wesentlichen Automatisierung von Handhabungsvorgängen verbunden. Nachdem die Träger (Trays) aus entsprechend temperaturbeständigem Material hergestellt werden, können die Bauelemente auch in Stationen, die mit einer Temperaturbelastung verbunden sind, in der entsprechenden Station auf dem Träger verbleiben. Eine Station bzw. eine Maschine ist so ausgelegt, daß die in einem angekoppelten Gehäuse vorhandenen Träger vollständig für einen Bearbeitungs- oder Prüfdurchgang aus dem Gehäuse entladen und in die Maschine aufgenommen werden. Dies bedeutet eine weitere Automatisierung des Verfahrens.

Durch die Handhabung der elektronischen Bauelemente auf Trägern, die stapelweise in einem Gehäuse untergebracht werden, wird auch ein Vertauschen der Bauelemente ausgeschlossen. Die Umstellung der Produktion auf ein automatisches Handhabungskonzept wird ermöglicht. Verwechslungsgefahren und Gefahr von Beschädigungen durch Umladevorgänge werden weitestgehend ausgeschlossen.

Die plattenförmigen Träger nehmen eine Vielzahl von Bauelementen auf, beispielsweise 20 x 70. Die Anzahl der in einem Stapel innerhalb eines Gehäuses vorhandenen Träger kann beispielsweise bei 10 oder 20 liegen. Die Form des Gehäuses ist entsprechend der Form eines durch Aufeinandersetzen von Trägern entstandenen Stapels angepaßt. Die Träger sind darin weitestgehend arretiert, wobei eine Zuführung eines Trägers im unteren Bereich des Gehäuses an einer Seitenfläche desselben geschieht. Ein Träger wird seitwärts eingeschoben und über entsprechende Halterungen federunterstützt gehalten. Der im Gehäuse bereits vorhandene Stapel wird schrittweise nach oben gedrückt, so daß, solange das Gehäuse nicht vollständig bestückt ist, weitere Träger eingeführt werden können.

Eine vorteilhafte Ausgestaltung der Erfindung sieht vor, daß das Gehäuse mit seiner Unterseite an einer Station angekoppelt wird. Somit werden die im Gehäuse enthaltenen Träger schrittweise von der Unterseite des Stapels entnommen und in die Station eingeführt. Beim Entladen der Station geschieht dieser Vorgang entsprechend umgekehrt.

Es ist besonders vorteilhaft, mehrere Gehäuse auf einer Station gleichzeitig anzukoppeln. Eine Station ist zweckmaßigerweise für die Kapazität von zwei Stapeln von Trägern, was der Kapazität von zwei Gehäusen entspricht, ausgelegt. Somit ist es möglich, den Inhalt von zwei Gehäusen gleichzeitig in eine Station einzugeben bzw. während der Bearbeitung oder Prüfung der Bauelemente eines Stapels von Trägern eine weitere Fertigungseinheit zwischen bzw. parallel zu schalten.

In vorteilhafter Weise werden Träger und Gehäuse mit einer Codierung versehen. Diese Codierung kann über entsprechend ausgelegte Lesegeräte während des gesamten Verfahrens innerhalb der Endmontage gelesen werden, so daß eine computerintegrierte Fertigung (CIM) ermöglicht wird. Als Codierungsmittel können beispielsweise Strichcodierungen (Barcode) eingesetzt werden. Bei der Codierung der Träger ist es vorteilhaft, sog. passive Fixcode-Träger (Transponder) zu verwenden.

Eine weitere vorteilhafte Ausgestaltung sieht vor, daß, ohne ein Gehäuse zu entladen, dieses vollständig mit einem Stapel von Trägern mit entsprechender Anzahl von elektronischen Bauelementen in eine Bearbeitungs- oder Prüfstation eingeführt wird. Dies ist beispielsweise denkbar, um den sog. Baking-Prozeß bei 150°C durchzuführen. Um einen problemlosen Wärmeübergang von einer Wärmequelle innerhalb der Station auf sämtliche elektronischen Bauelemente zu gewährleisten, muß das Gehäuse entsprechende Aussparungen aufweisen. Ebenso muß der Stapel aus Trägern Zwischenräume aufweisen, um beispielsweise ein auf die entsprechende Temperatur aufgeheiztes Prozeßgas hindurchtreten zu lassen und somit die Bauelemente aufzuheizen.

Die insgesamten Vorteile der Erfindung bestehen darin, Verwechslungen von verschiedenen Fertigungseinheiten zu vermeiden und die Handhabung, Sortierung und Beschädigung der Bauelemente zu verringern. Durch den gleichzeitigen Einsatz von Codierungen an den Transportmitteln ist eine Verfolgung eines Fertigungsloses und eine CIM (Computer integrierte Herstellung)-Anbindung möglich. Damit ist zu jeder Zeit der aktuelle Stand des Verfahrens der Endmontage dokumentierbar.

Durch die integrierte Codierung von Trägern und Gehäusen in Verbindung mit Datenbankanbindungen und Vernetzungen ist eine papierlose Fertigungskontrolle möglich.

Im folgenden wird anhand von drei schematischen Figuren ein Ausführungsbeispiel beschrieben.
Figur 1 zeigt die Draufsicht auf einen Teil eines Trägers 1, der eine Vielzahl von elektronischen Bauelementen 2 trägt,
Figur 2 zeigt ein Gehäuse 4,
Figur 3 zeigt ein optische Codierungseinrichtung.

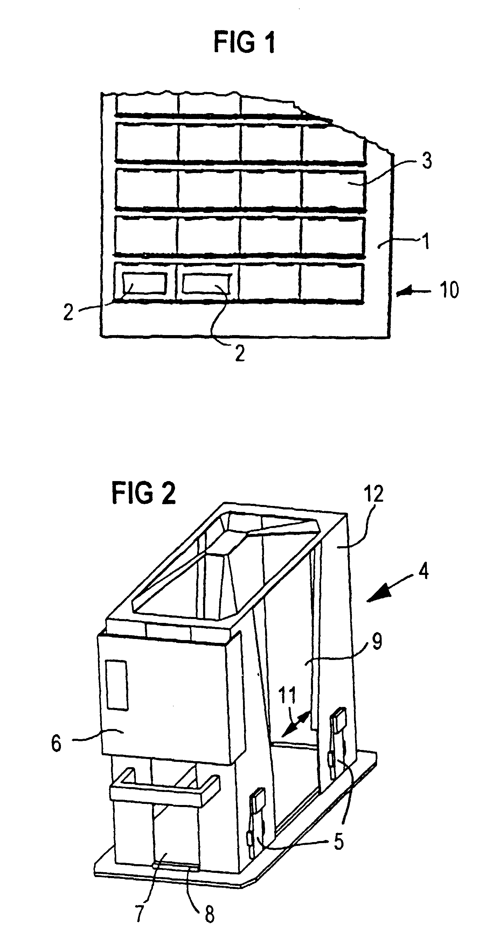

In der Figur 1 ist schematisch ein Ausschnitt aus einem Träger 1 (Tray) dargestellt. Die elektronischen Bauelemente 2 liegen in wannenförmigen Vertiefungen 3. Der Träger weist insgesamt einen rechteckigen Grundriß auf. Der Träger 1 entsprechend Figur 1 könnte beispielsweise 4 x 11 wannenförmige Vertiefungen 3 beinhalten. Ein Codierungselement 10 wäre beispielsweise in einer Seite des Trägers 1 plazierbar. Da die Träger 1 in der Regel aus gespritztem Kunststoff bestehen, ist es möglich, eine Strichcodierung anzubringen, die oberflächlich sichtbar ist und somit optisch wahrgenommen werden kann. Ein passiver Fixcode-Träger (Transponder), der magnetische Codierungen beinhaltet, kann elektromagnetisch ausgelesen werden.

In der Figur 2 wird ein Typ eines Gehäuses 4 dargestellt. Das Gehäuse 4 besteht aus einer Bodenplatte 7, einem Aufbau 12, der nicht geschlossen ist, Aussparungen 9 innerhalb des Aufbaus 12 und einer Kennzeichnungstafel 6. In Figur 2 ist die Be- oder Entladerichtung 11 angedeutet. Die Träger 1 werden seitwärts an der Unterseite eines eventuell bereits im Gehäuse 4 enthaltenen Stapels von Trägern 1 eingeschoben und mittels des Anschlages 8 in dieser Richtung arretiert. Die federunterstützten Halterungen 5, die in der dargestellten Version vier mal vorhanden sind (zwei mal nicht sichtbar) sorgen für eine Halterung eines im Gehäuse 4 befindlichen Stapels von Trägern 1. Des weiteren wird dieser Stapel beim Beladen des Gehäuses 4 derart nach oben geschoben, daß schrittweise ein weiterer Träger 1 einführbar ist. Auf der Kennzeichnungstafel 6 lassen sich Kennzeichen jedweder Art anbringen. Das Gehäuse 4 muß nicht notwendigerweise die gleiche Art der Codierung aufweisen, wie ein Träger 1.

Um unbefugten Zugriff auf elektronische Bauelemente zu vermeiden, kann der oberste Träger 1 eines in einem Gehäuse 4 befindlichen Stapels mit einer Abdeckhaube (nicht dargestellt) versehen werden. Die nachfolgenden darunterliegenden Träger 1 werden durch den jeweils darüberliegenden Träger 1 geschützt. Es ist denkbar, das Gehäuse abschließbar auszugestalten. Weiterhin besteht die Möglichkeit, falls ausreichende Stabilität gewährleistet ist, zumindest den Aufbau 12 des Gehäuses 4 aus einem Gitter herzustellen. Die Öffnungen bzw. Aussparungen 9 sorgen dafür, daß die Verwendung des Gehäuses mit einem darin enthaltenen Stapel von Trägern 1 und den entsprechenden Bauelementen 2 in einer Station möglich ist. Falls eine Temperaturbehandlung für die elektronischen Bauelemente in den Trägern innerhalb des Gehäuses 4 vorgesehen ist, so ist zu gewährleisten, daß die entsprechende Prozeßtemperatur auch auf jedes der Bauelemente 2 einwirken kann.

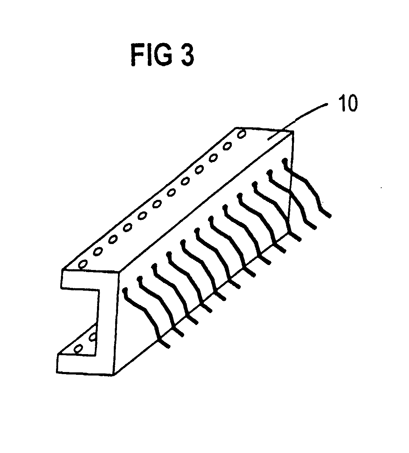

In Figur 3 wird ein Codierungselement 10 dargestellt. Dieses Codierungselement 10 kann beispielsweise in einem Gehäuse 4 verwendet werden. Auf der rechten sichtbaren Seite befinden sich insgesamt zwölf elektrische Anschlüsse. Die beiden Schenkel des im Querschnitt U-förmigen liegenden Profiles, das seitwärts geöffnet ist, enthalten jeweils gegenüberliegend zwölf Paare von Bohrungen. Diese werden paarweise mit einer Lichtquelle und einem Fotosensor verbunden, so daß eine korespondierende, beispielsweise an einem Träger 1 oder auch an einem Gehäuse 4 befindliche Leiste mit Zapfen, die eine Codierung enthält, eingreifen kann und lesbar ist. Dieses Zwölferlochcode-System bietet die Möglichkeit von ausreichend vielen Klassifizierungsnummern.

Ein Gehäuse 4, das auch als Sleeve bezeichnet wird, paßt in jede Maschine in der Endmontage bzw. kann an jede Maschine angekoppelt werden. In der Regel wird ein Fertigungslos (Fertigungseinheit) in einem Gehäuse 4 transportiert.

Die Möglichkeit eines Gehäusewechsels während eines Arbeitsvorganges innerhalb einer Station kann den Ablauf in der Endmontage wesentlich beschleunigen.

## Patentansprüche

1. Verfahren zur Handhabung von kunststoffumspritzten elektronischen Bauelementen (2) an und zwischen Bearbeitungs- und Prüfstationen in der Endmontage, wobei
- eine Vielzahl von Bauelementen (2) auf einem plattenförmigen Träger (1) abgelegt werden,
- mehrere Träger (1) zu einem Stapel zusammengefaßt werden und dieser Stapel in einem teilweise offenen Gehäuse (4) untergebracht wird,
- die Bauelemente (2) als Fertigungseinheit mit dem Gehäuse (4) transportiert werden und
- das Gehäuse (4) an jede Station ankoppelbar ist, so daß die Träger (1) zwischen dem Gehäuse (4) und der Station austauschbar sind.

2. Verfahren nach Anspruch 1, worin das Be- bzw. Entladen des Gehäuses (4) mit Trägern (1) am unteren Ende einer Seitenfläche des Gehäuses (4) in Be- bzw. Entladerichtung (11) geschieht.

3. Verfahren nach einem der vorhergehenden Ansprüche, worin die Träger (1) durch federunterstützte Halterungen (5) nacheinander im Gehäuse stapelbar sind und beim Entladen nacheinander entnehmbar sind.

4. Verfahren nach einem der vorhergehenden Ansprüche, worin das Gehäuse (4) mit seiner Unterseite an eine Station ankoppelbar ist.

5. Verfahren nach einem der vorhergehenden Ansprüche, worin mehrere Gehäuse (4) gleichzeitig an eine Station ankoppelbar sind.

6. Verfahren nach einem der vorhergehenden Ansprüche, worin Träger (1) und/oder Gehäuse (4) jeweils eine Codierung aufweisen, wobei mittels entsprechender Lesegeräte eine Überwachung der Bauelemente (2) während der Endmontage geschieht.

7. Verfahren nach einem der vorhergehenden Ansprüche, worin ein Stapel von Trägern (1) vollständig mit dem Gehäuse (4) in eine Bearbeitungs- oder Prüfstation zur Bearbeitung oder Prüfung der Bauelemente (2) eingesetzt wird.

8. Verfahren nach Anspruch 6, worin die Träger (1) Fixcode-Träger enthalten.

## Claims

1. Process for handling plastic-encapsulated electronic components (2) at and between work stations and inspection stations in final assembly,
- a multiplicity of components (2) being deposited on a plate-like support (1)
- a plurality of supports (1) being combined to form a stack, and this stack being accommodated in a partially open housing (4),
- the components (2) being transported as a production unit together with the housing (4), and
- it being possible to couple the housing (4) to each station, so that the supports (1) can be exchanged between the housing (4) and the station.

2. Process according to Claim 1, wherein supports (1) are loaded into and unloaded from the housing (4) at the lower end of a side face of the housing (4) in the loading or unloading direction (11).

3. Process according to one of the preceding claims, wherein the supports (1) can be successively stacked in the housing by means of spring-assisted securing devices (5) and can be successively removed during unloading.

4. Process according to one of the preceding claims, wherein the underside of the housing (4) can be coupled to a station.

5. Process according to one of the preceding claims, wherein a plurality of housings (4) can be coupled simultaneously to one station.

6. Process according to one of the preceding claims, wherein support (1) and/or housing (4) each have a coding, the components (2) being monitored during final assembly by means of corresponding reading devices.

7. Process according to one of the preceding claims, wherein a stack of supports (1), complete with the housing (4), is inserted into a work station or inspection station for processing or inspecting the components (2).

8. Process according to Claim 6, wherein the supports (1) contain fixed code supports.

## Revendications

1. Procédé de manipulation de composants électroniques (2) enrobés par injection de matière synthétique aux stations de contrôle et de traitement du montage final, et entre celles-ci, dans lequel
- un grand nombre de composants (2) sont posés sur un support (1) en forme de plaque,
- plusieurs supports (1) sont regroupés en une pile et cette pile est logée dans un boîtier (4) partiellement ouvert,
- les composants (2) sont transportés avec le boîtier 4 en tant qu'unité de production, et
- le boîtier (4) peut être accouplé à chaque station, si bien que les supports (1) sont échangeables entre le boîtier (4) et la station.

2. Procédé selon la revendication 1, dans lequel le chargement et le déchargement du boîtier (4) avec des supports (1) se produit à l'extrémité inférieure d'une paroi latérale du boîtier (4) en direction de chargement ou de déchargement (11).

3. Procédé selon l'une quelconque des revendications précédentes, dans lequel les supports (1) sont successivement empilables dans le boîtier grâce à des fixations à ressorts (5) et successivement extractibles lors du déchargement.

4. Procédé selon l'une quelconque des revendications précédentes, dans lequel le boîtier (4) peut être accouplé par son côté inférieur à une station.

5. Procédé selon l'une quelconque des revendications précédentes, dans lequel plusieurs boîtiers (4) peuvent être accouplés simultanément à une station.

6. Procédé selon l'une quelconque des revendications précédentes, dans lequel des supports (1) et/ou des boîtiers (4) présentent chacun une codification, grâce à quoi un contrôle des composants (2) est réalisé lors du montage final au moyen d'appareils de lecture appropriés.

7. Procédé selon l'une quelconque des revendications précédentes, dans lequel une pile de supports (1) est introduite entièrement avec le boîtier (4) dans une station de traitement ou de contrôle pour traitement ou contrôle des composants (2).

8. Procédé selon la revendication 6, dans lequel les supports (1) comprennent un porteur de code fixe.
